# EUROPÄISCHE PATENTSCHRIFT

(11) **EP 1 544 626 B1**
(45) Veröffentlichungstag und Bekanntmachung des Hinweises auf die Patenterteilung: **25.07.2012**
(21) Anmeldenummer: 04028522.3
(22) Anmeldetag: 02.12.2004
(51) Int. Cl.: G01R 11/04, G01R 11/24

(54) **Anschlusssystem für Stromzähler**
Connection system for electricity meters
Système de raccordement pour compteurs d'électricité

(30) Priorität: 16.12.2003 DE 10359139
(43) Veröffentlichungstag der Anmeldung: 22.06.2005
(60) Teilanmeldung: 10011552.6
(73) Patentinhaber: Hager Electro GmbH & Co. KG, 66440 Blieskastel (DE)
(72) Erfinder: Kelaiditis, Konstantin Dr.Ing., 66386 St.Ingbert (DE); Zimmermann, Michael, 66399 Mandelbachtal (DE); CLemens, Guntram Dr.Ing, 90409 Nürnberg (DE)
(74) Vertreter: Bernhardt, Winfrid

(56) Entgegenhaltungen:
- DE-A1- 4 116 218
- DE-A1- 10 052 998
- DE-A1- 10 261 206
- DE-A1- 10 323 160
- DE-U1- 9 313 573
- DE-U1- 20 216 393
- DE-U1- 29 703 973
- DE-U1- 29 703 981
- DE-U1- 29 703 982
- US-A- 2 086 495
- US-A- 4 311 354
- US-A- 4 368 943
- US-A- 4 534 487
- US-A- 5 181 166
- US-A- 5 586 913
- US-A- 5 704 804
- US-A- 5 982 611
- US-A1- 2002 041 480
- US-B1- 6 475 028

## Beschreibung

Die Erfindung betrifft ein Anschlusssystem für elektronische Stromzähler, mit einer Basisplattform und einer an der Basisplattform als Gesamtheit montierbaren Baugruppe für die Aufnahme des Stromzählers, wobei die Aufnahmebaugruppe sämtliche zur elektrischen und mechanischen Ankopplung des Stromzählers erforderlichen Elemente aufweist und zur Ankopplung des Stromzählers unter Verschiebung des Stromzählers parallel zu der Basisplattform ausgebildet ist, so dass von dem Stromzähler rückseitig vorstehende Kontaktstücke in elektrischen Kontakt mit innerhalb der Aufnahmebaugruppe vorgesehenen Anschlusselementen kommen und rückseitig vorstehende Hakenelemente Gehäuseteile der Aufnahmebaugruppe hintergreifen.

Die Offenlegungsschriften DE 102 61 206 A1, DE 103 23 160 A1, DE 103 13 999 A1, DE 103 23 261 A1 und DE 103 23 161 A1 beschreiben Anschlussvorrichtungen für solche elektronischen Stromzähler, deren Verbindungs- und Anschlusselemente sich von herkömmlichen Zählern unterscheiden. Von dem gegen eine Tragplatte anlegbaren Boden des Stromzählergehäuses stehen durch Öffnungen in der Tragplatte hindurchführbare Kontaktstücke entsprechend wenigstens einer Stromphase vor, welche durch Verschiebung des auf der Tragplatte geführten Gehäuses mit Strom zu- und abführenden Anschlusselementen auf der dem Stromzähler abgewandten Seite der Tragplatte verbindbar sind. Gemäß der DE 102 61 206 A1, die ein Anschlusssystem der eingangs genannten Art beschreibt, ist ein Zähler über einen Adapter an eine Zählertragplatte für herkömmliche Zähler anschließbar, wobei der Adapter am Zählerkreuz der Zählertragplatte befestigt wird.

Die US 2002/0041480 A1 beschreibt ein Anschlusssystem für einen Stromzähler mit einer Basisplattform 14, an der eine aus einem Rahmen 15 und einem Stecksockel 26 bestehende, an der Basisplattform 14 montierbare Aufnahmebaugruppe 10 vorgesehen ist. Durch eine Öffnung 17 in der Basisplattform 14 hindurch lässt sich ein aufsteckbarer Stromzähler 12 in den Stecksockel 26 der Aufnahmebaugruppe 10 einführen. Die Aufnahmebaugruppe 10 bildet einen Adapter, der den Anschluss des genannten steckbaren Stromzählers 12 an der Basisplattform 14 ermöglicht. Die aus dem Rahmen 18 und dem Aufnahmesockel 26 für den aufsteckbaren Stromzähler 12 gebildete Aufnahmebaugruppe 10 lässt sich von hinten her an die Basisplattform 14 heranführen und mittels Schrauben befestigen.

Die DE 41 16 218 A1 beschreibt eine Vorrichtung zur lösbaren Befestigung eines elektrischen Einbaugerätes, wie einer Steckdose, einem Schalter, einem Taster, einem Lichtzeichen, einem Dimmer oder dergleichen in einer Einbauöffnung in einer Gerätewand.

Der vorliegenden Erfindung liegt die Aufgabe zugrunde, ein neues Anschlusssystem der eingangs erwähnten Art für elektronische Stromzähler zu schaffen, das den für solche elektronische Stromzähler stellenden Anforderungen gerecht wird.

Diese Aufgabe wird durch die im Anspruch 1 angegebenen Merkmale gelöst.

Gemäß der Erfindung ist ein Anschlusssystem für Stromzähler derart modular aufgebaut, dass der Anschluss des Stromzählers an die Plattform über eine gesonderte Baugruppe erfolgt. Wenn gemäß einer Ausführungsform der Erfindung die Basisplattform mehrere Sitze für die Aufnahme einer solchen Aufnahmebaugruppe aufweist, brauchen bei Nichtnutzung von Sitzen nicht alle Ankopplungselemente vorhanden zu sein. Erst bei einer Nachrüstung werden diese Elemente ergänzt.

In einer besonders bevorzugten Ausführungsform der Erfindung ist die Aufnahmebaugruppe sowohl von der Rückseite als auch der Vorderseite der Basisplattform her an der Basisplattform montierbar. Zweckmäßig ist eine einrastende Steckverbindung vorgesehen, die eine schnelle Montage ohne Werkzeug ermöglicht.

Die Möglichkeit zur Montage der Aufnahmebaugruppe von der Rückseite der Plattform her ist für die Produktion vorteilhaft, insbesondere dann, wenn gemäß einer Ausführungsform der Erfindung die Aufnahmebaugruppe mit in Anschlussräume zu führenden Anschlussleitern vorgefertigt ist. Die hinter der Basisplattform verlegten Anschlussleiter brauchen dann nicht eingefädelt zu werden. Die Montagemöglichkeit von der Vorderseite her erleichtert Nachrüstungen von Zählern und Aufnahmebaugruppen wie auch den Austausch von Zählern, z.B. zur Umstellung auf einen höheren Grenzstrom.

In weiterer Ausgestaltung der Erfindung kann es sich bei den Anschlussleitern um wenigstens teilweise starre, der Anschlussgeometrie entsprechend vorgeformte Leiter handeln. Letztere lassen sich nur montieren, wenn auch die Montagemöglichkeit von der Rückseite der Basisplattform her gegeben ist.

Die mit der Aufnahmebaugruppe vorgefertigten starren Leiter können mit einer Klemmleiste, insbesondere einer Hauptleitungsabzweigklemme verbunden sein, wobei die Klemmleiste entweder an die Basisplattform oder/und eine Hutprofilschiene in einem Anschlussraum koppelbar sein kann.

Die starren Anschlussleiter können ferner ein mit einem weiteren Anschlussleiter verbindbares Kontaktstück der genannten Klemmleiste bilden, was die Konstruktion der Klemmleiste vorteilhaft vereinfacht.

Die starren Leiter können unmittelbar in Kontakt mit einem Kontaktstück des Stromzählers stehen. Gesonderte Anschlusskontaktstücke für die Anschlussleiter an der Aufnahmebaugruppe sind dann überflüssig.

Die Aufnahmebaugruppe lässt sich sowohl mit nach oben als auch nach unten von der Baugruppe wegführenden Leitern vorfertigen.

In weiterer Ausgestaltung der Erfindung ist ein Nullleiter ununterbrochen durch die Aufnahmebaugruppe hindurch verlegt und innerhalb der Aufnahmebaugruppe, ggf. durch eine Messerkontaktierung, angeschlossen. Auch hierbei kann es sich um einen wenigstens teilweise starren Leiter handeln, der unmittelbar in Kontakt mit einem Kontaktstück des Zählers kommt. Gesonderte Anschlusselemente entfallen.

Der wenigstens teilweise starre Nullleiter kann einen ggf. verformten Abschnitt aufweisen, mit dem er federnd gegen das Kontaktstück des Stromzählers anliegt.

In weiterer vorteilhafter Ausgestaltung der Erfindung sind Einrichtungen zur Sicherung der Aufnahmebaugruppe in ihrer Montagestellung auf der Basisplattform vorgesehen. Eine solche Sicherung kann durch einen Teil des Stromzählers, z.B. ein Verhakungselement, gebildet sein. Ein die Steckverbindung bildendes Element umfasst zweckmäßig Einrichtungen zur Demontage der Aufnahmebaugruppe, wobei das Element zweckmäßig durch den in seiner Betriebsstellung plombierten Stromzähler versperrt und daher nicht zugänglich ist.

Auch ein die Rastverbindung bildendes Element kann Einrichtungen zur Lösung der Rastverbindung aufweisen.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: eine Schemadarstellung einer Zählerschrankinstallation mit einem Anschlusssystem gemäß der Erfindung,
- Fig. 2: eine schematische Querschnittsansicht A-A gemäß einem ersten Ausführungsbeispiel für ein Anschlusssystem nach der Erfindung,
- Fig. 3: eine dem Anschlusssystem von Fig. 2 zugehörige Basisplattform vor der Installation eines Stromzählers,
- Fig. 4: Details des Anschlusssystems von Fig. 2 und 3,
- Fig. 5: ein zweites Ausführungsbeispiel für ein Anschlusssystem nach der Erfindung, und
- Fig. 6: einen direkten Anschluss eines Nullleiters an ein Kontaktstück eines Stromzählers.

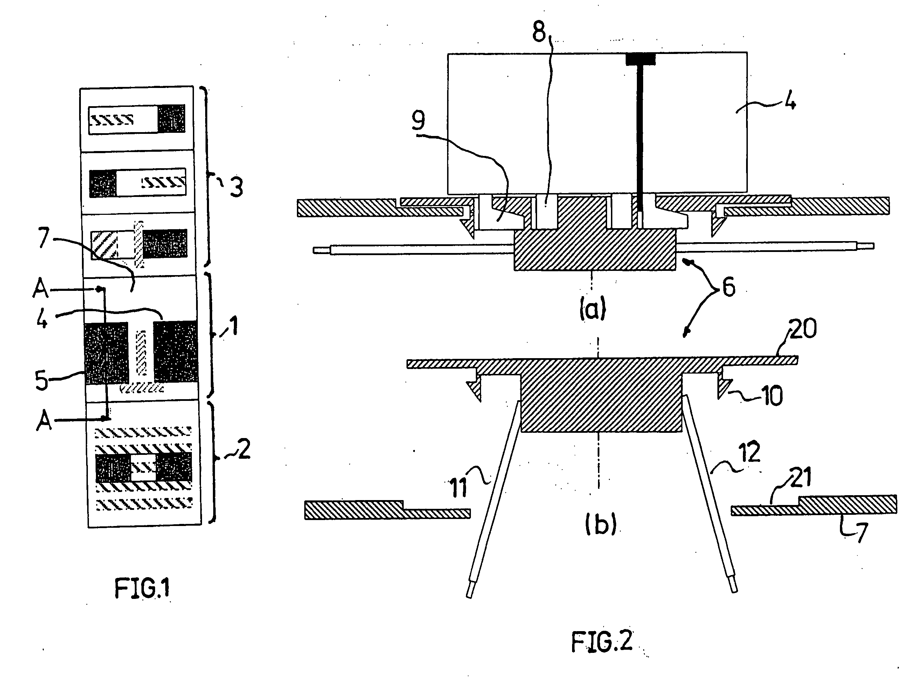

Eine in Fig. 1 gezeigte Zählerschrankinstallation weist einen ein Anschlusssystem für Stromzähler enthaltenden Abschnitt 1 sowie einen unteren und oberen Anschlussraum bildende Abschnitte 2 und 3 auf.

In dem Abschnitt 1 bestehen in dem betrachteten Fall Anschlussmöglichkeiten für zwei Stromzähler 4 und 5.

Aus der dem Schnitt A-A von Fig. 1 entsprechenden Darstellung von Fig. 2 ist erkennbar, dass der Stromzähler 4 mit einer Aufnahmebaugruppe 6 verbindbar ist, die ihrerseits mit einer Basisplattform 7 verbunden werden kann.

Während der Stromzähler 4 über von seiner Rückseite vorstehende Kontaktstücke 8 elektrisch und über Hakenelemente 9 mechanisch mit der Aufnahmebaugruppe 6 verbunden werden kann, ist die Aufnahmebaugruppe 6 auf die Basisplattform 7 aufsteckbar, wobei hinterschnittene Rastnasen 10 an der Basisplattform einrasten und Verlängerungen 20 der Aufnahmebaugruppe 6 in Randeinsenkungen 21 der Basisplattform eingreifen.

Zur elektrischen und mechanischen Verbindung mit der Aufnahmebaugruppe 6 ist der Zähler 4 parallel zur Basisplattform zu verschieben, wobei die Kontaktstücke 8 in elektrischen Kontakt mit innerhalb der Aufnahmebaugruppe vorgesehenen Anschlusselementen kommen und die Hakenelemente 9 Teile des Gehäuses der Aufnahmebaugruppe 6 hintergreifen, so dass der Zähler in Richtung senkrecht zur Basisplattform nicht mehr von der Aufnahmebaugruppe 6 abhebbar ist.

Die Aufnahmebaugruppe 6 ist komplett vorgefertigt mit hinter der Basisplattform 7 zu verlegenden, flexiblen Anschlussleitern 11 und 12, wobei die Anschlussleiter 11 in den oberen Anschlussraum und die Leiter 12 in den unteren Anschlussraum zu führen sind.

Für den Anschluss des Zählers 5 ist ein dem Anschlusssystem von Fig. 2 entsprechendes System vorgesehen.

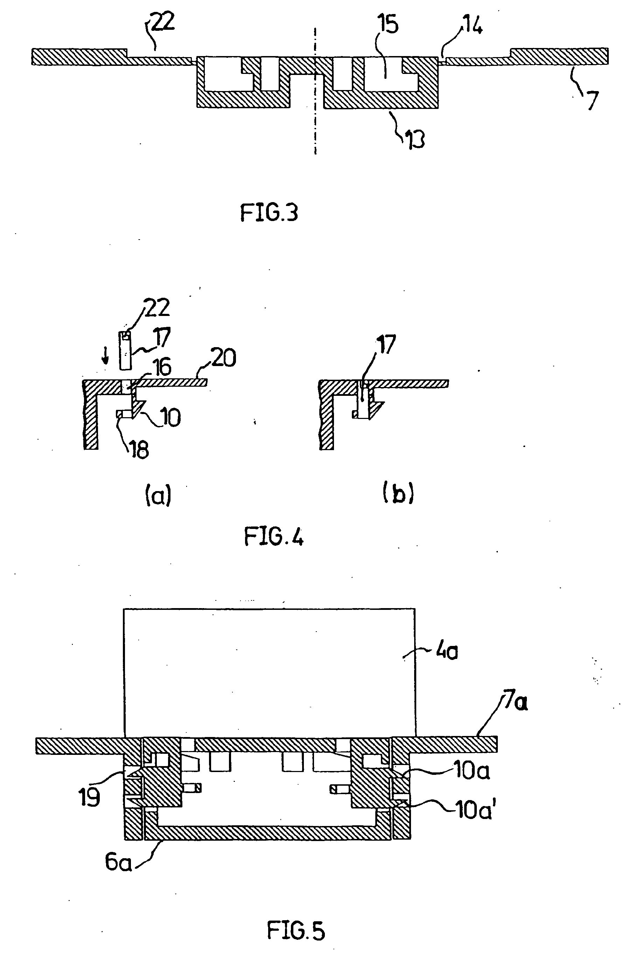

Wie aus Fig. 3 hervorgeht, weist die Basisplattform 7 ein plattenartiges Teil 13 auf, das über Schwachstellen 14 mit der übrigen Basisplattform verbunden und zur Bildung eines Sitzes für den Zähler 4 bzw. 5 aus der Basisplattform 7 ausbrechbar ist. In dem Teil 13 vorgesehene Räume 15 dienen einerseits der Meidung von Materialhäufungen und können andererseits vor Installation eines Stromzählers zur Unterbringung von Teilen, ggf. Verbindungselementen und dergleichen, genutzt werden.

Aus Fig. 4 gehen in Fig. 2 und 3 nicht sichtbare Details hervor. An wenigstens einer der Rastnasen 10 ist ein Durchgang 16 für die Aufnahme eines Sicherungsstifts 17 gebildet, welcher verhindert, dass sich die Rastnasen verbiegen und sich die Aufnahmebaugruppe auf ihrer eingerasteten Steckverbindung mit der Basisplattform 7 lösen kann. Wie Fig. 2a erkennen lässt, ist dieser Sicherungsstift 17 durch den in seiner Betriebslage zu plombierenden Zähler 4 abgedeckt und daher nicht zugänglich. Zur Demontage der Aufnahmebaugruppe 6 von der Basisplattform 7 kann ein einen Teil des Durchgangs 16 bildender Ansatz 18 an der Rastnase 10 dazu verwendet werden, die Rastnase aus ihrer Verhakungsstellung mit der Basisplattform 7 zu lösen, indem z.B. in den betreffenden Abschnitt des Durchgangs 16 ein Werkzeug eingeführt wird. Eine gestufte Ausnehmung 22 am Sicherungsstift kann zum Herausziehen des Stifts aus dem Durchgang 16 genutzt werden.

Es wird nun auf Fig. 5 Bezug genommen, wo gleiche oder gleichwirkende Teile mit derselben Bezugszahl wie in Fig. 2 und 3 bezeichnet sind, wobei der betreffenden Bezugszahl der Buchstabe a beigefügt ist.

Eine kastenartige Aufnahmebaugruppe 6a weist mehrere Paare vorstehender Rastnasen 10a und 10a' auf, die in Ausnehmungen 19 in einer Abwinklung an einer Basisplattform 7a eingreifen. Wie Fig. 5 erkennen lässt, weisen die Rastnasen in entgegengesetzten Richtungen geneigte Schrägen auf, so dass die Aufnahmebaugruppe 6 sowohl von der Vorderseite der Plattform 7a her als auch von deren Rückseite aus auf die Basisplattform aufsteckbar sind.

Die Montage des Zählers 4a an der Aufnahmebaugruppe erfolgt in gleicher Weise wie bei dem Ausführungsbeispiel von Fig. 2.

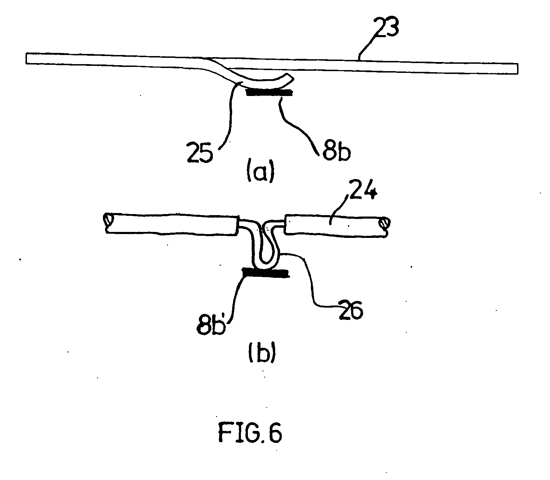

Fig. 6 zeigt durch eine Baugruppe hindurch verlegte Nullleiter 23 und 24. Eine ausgebogene Nase 25 des Leiters 23 liegt federnd gegen ein Kontaktstück 8b eines Stromzählers an.

Der in Fig. 6b gezeigte Leiter 24 ist flexibel und liegt mit einer Schleife 26 gegen ein Kontaktstück 8b' eines Stromzählers an.

## Patentansprüche

1. Anschlusssystem für elektronische Stromzähler (4,5), mit einer Basisplattform (7) und einer an der Basisplattform (7) als Gesamtheit montierbaren Aufnahmebaugruppe (6) für die Aufnahme des Stromzählers (4,5), wobei die Aufnahmebaugruppe (6) sämtliche zur elektrischen und mechanischen Ankopplung des Stromzählers (4,5) erforderlichen Elemente aufweist und zur Ankopplung des Stromzählers (4,5) unter Verschiebung des Stromzählers (4,5) parallel zu der Basisplattform (7) ausgebildet ist, so dass von dem Stromzähler (4,5) rückseitig vorstehende Kontaktstücke (8) in elektrischen Kontakt mit innerhalb der Aufnahmebaugruppe vorgesehenen Anschlusselementen kommen und rückseitig vorstehende Hakenelemente (9) Gehäuseteile der Aufnahmebaugruppe (6) hintergreifen, wobei
in der Basisplattform (7) zur Bildung eines Sitzes für die Aufnahmebaugruppe (6) oder mehrerer Sitze für jeweils eine solche Aufnahmebaugruppe (6) je ein Durchbruch vorgesehen ist oder die Basisplattform (6) wenigstens einen zur Bildung eines solchen Sitzes für die Aufnahmebaugruppe (6) an Schwachstellen (14) ausbrechbaren Teil (13) aufweist, die Aufnahmebaugruppe (6) auf die Basisplattform (7, 7a) einrastend aufsteckbar ist und in dem Sitz mit Verlängerungen (20) der Aufnahmebaugruppe (6) in Randeinsenkungen (21) der Basisplattform (7) oder mit mehreren Paaren vorstehender Rastnasen (10a, 10a') in Ausnehmungen (19) in einer Abwinklung der Basisplattform (7a) eingreift und an die Aufnahmebaugruppe (6) geführte Anschlussleiter (11,12) hinter der Basisplattform verlegt sind.

2. System nach Anspruch 1,
**dadurch gekennzeichnet,**
**dass** die Aufnahmebaugruppe (6,6a) von der Rückseite oder/und der Vorderseite der Basisplattform (7,7a) her an der Basisplattform montierbar ist.

3. System nach einem der Ansprüche 1 oder 2,
**dadurch gekennzeichnet,**
**dass** die Aufnahmebaugruppe (6) mit in Anschlussräume (2, 3) führenden Leitern (11, 12) vorgefertigt ist.

4. System nach einem der Ansprüche 1 bis 3,
**dadurch gekennzeichnet,**
**dass** Einrichtungen (16,17) zur Sicherung der Aufnahmebaugruppe (6) in ihrer Montagestellung auf der Basisplattform (7) vorgesehen sind.

5. System nach Anspruch 4,
**dadurch gekennzeichnet,**
**dass** die Sicherung durch einen Teil des Stromzählers (4) gebildet ist.

6. System nach Anspruch 5,
**dadurch gekennzeichnet,**
**dass** ein die Sicherung bildendes Element Einrichtungen (18) zur Demontage der Aufnahmebaugruppe umfasst.

7. System nach einem der Ansprüche 1 bis 6,
**dadurch gekennzeichnet,**
**dass** ein eine Rastverbindung bildendes Element (10) Einrichtungen (18) zur Lösung der Rastverbindung aufweist.

8. System nach Anspruch 6 oder 7,
**dadurch gekennzeichnet,**
**dass** das Element (10) durch den Stromzähler (4) versperrt ist.

9. System nach einem der Ansprüche 1 bis 7,
**dadurch gekennzeichnet,**
**dass** die Aufnahmebaugruppe mit wenigstens teilweise starren, der Anschlussgeometrie entsprechend vorgeformten Anschlussleitern vorgefertigt ist.

10. System nach Anspruch 9,
**dadurch gekennzeichnet,**
**dass** die starren Leiter der vorgefertigten Aufnahmebaugruppe mit einer Klemmleiste, insbesondere Hauptleitungsabzweigklemme, verbunden sind.

11. System nach Anspruch 10,
**dadurch gekennzeichnet,**
**dass** die Klemmleiste an die Basisplattform oder/und einer Hutprofilschiene in einem Anschlussraum koppelbar ist.

12. System nach einem der Ansprüche 9 bis 11,
**dadurch gekennzeichnet,**
**dass** die starren Anschlussleiter ein mit einem weiteren Anschlussleiter verbindbares Kontaktstück der Klemmleiste bilden.

13. System nach einem der Ansprüche 1 bis 12,
**dadurch gekennzeichnet,**
**dass** die Aufnahmebaugruppe (6) mit sowohl nach oben als auch nach unten von der Baugruppe wegführenden Leitern (11,12) vorgefertigt ist.

14. System nach einem der Ansprüche 9 bis 12,
**dadurch gekennzeichnet,**
**dass** die starren Anschlussleiter unmittelbar in Kontakt mit einem Kontaktstift des Stromzählers kommen.

15. System nach einem der Ansprüche 1 bis 14,
**dadurch gekennzeichnet,**
**dass** ein Nullleiter ununterbrochen durch die Aufnahmebaugruppe hindurchgeführt und innerhalb der Baugruppe, ggf. durch eine Messerkontaktierung, kontaktiert ist.

16. System nach Anspruch 15,
**dadurch gekennzeichnet,**
**dass** der Nullleiter wenigstens teilweise starr ist und ggf. unmittelbar, ggf. federnd, direkt mit einem Kontaktstück des Stromzählers in Kontakt kommt.

## Claims

1. Connection system for electronic electricity meters (4, 5), having a base platform (7) and an accommodation assembly (6), which can be mounted on the base platform (7) as a complete unit, for accommodating the electrical meter (4, 5), with the accommodation assembly (6) having all the elements which are required for electrically and mechanically coupling the electricity meter (4, 5) and being designed to couple the electricity meter (4, 5) with displacement of the electricity meter (4, 5) parallel to the base platform (7), so that contact pieces (8) which protrude from the rear face of the electricity meter (4, 5) come into electrical contact with connection elements which are provided inside the accommodation assembly, and hook elements (9) which protrude from the rear face engage behind housing parts of the accommodation assembly (6), with a respective aperture being provided in the base platform (7) in order to form a seat for the accommodation assembly (6) or a plurality of seats for an accommodation assembly (6) of this kind in each case, or the base platform (6) having at least one part (13) which can be broken through at weak points (14) in order to form a seat of this kind for the accommodation assembly (6), it being possible for the accommodation assembly (6) to be plugged in a latching manner onto the base platform (7, 7a) and the said accommodation assembly engaging in the seat by way of extensions (20) of the accommodation assembly (6) in edge recesses (21) in the base platform (7) or by way of several pairs of protruding latching lugs (10a, 10a') in recesses (19) in an angled portion of the base platform (7a), and connection conductors (11, 12), which are routed on the accommodation assembly (6), being laid behind the base platform.

2. System according to Claim 1,
**characterized**
**in that** the accommodation assembly (6, 6a) can be mounted on the base platform from the rear face or/and the front face of the base platform (7, 7a).

3. System according to either of Claims 1 and 2,
**characterized**
**in that** the accommodation assembly (6) is prefabricated with conductors (11, 12) which are routed into connection areas (2, 3).

4. System according to one of Claims 1 to 3,
**characterized**
**in that** devices (16, 17) for securing the accommodation assembly (6) in its mounting position on the base platform (7) are provided.

5. System according to Claim 4,
**characterized**
**in that** the securing means is formed by a part of the electricity meter (4).

6. System according to Claim 5,
**characterized**
**in that** an element which forms the securing means comprises devices (18) for removing the accommodation assembly.

7. System according to one of Claims 1 to 6,
**characterized**
**in that** an element (10) which forms a latching connection has devices (18) for releasing the latching connection.

8. System according to Claim 6 or 7,
**characterized**
**in that** the element (10) is locked by the electricity meter (4).

9. System according to one of Claims 1 to 7,
**characterized**
**in that** the accommodation assembly is prefabricated with at least partially rigid connection conductors which are preshaped so as to match the connection geometry.

10. System according to Claim 9,
**characterized**
**in that** the rigid conductors of the prefabricated accommodation assembly are connected to a terminal strip, in particular main line branch terminal.

11. System according to Claim 10,
**characterized**
**in that** the terminal strip can be coupled to the base platform or/and to a top-hat profile rail in a connection area.

12. System according to one of Claims 9 to 11,
**characterized**
**in that** the rigid connection conductors form a contact piece of the terminal strip, which contact piece can be connected to a further connection conductor.

13. System according to one of Claims 1 to 12,
**characterized**
**in that** the accommodation assembly (6) is prefabricated with conductors (11, 12) which are routed away from the assembly both at the top and at the bottom.

14. System according to one of Claims 9 to 12,
**characterized**
**in that** the rigid connection conductors come immediately into contact with a contact pin of the electricity meter.

15. System according to one of Claims 1 to 14,
**characterized**
**in that** a neutral conductor is routed through the accommodation assembly in an uninterrupted manner and contact is made with the said neutral conductor inside the assembly, possibly by a blade contact-making means.

16. System according to Claim 15,
**characterized**
**in that** the neutral conductor is at least partially rigid and comes into contact directly with a contact piece of the electricity meter, possibly immediately, possibly in a resilient manner.

## Revendications

1. Système de raccordement pour compteur d'électricité électronique (4, 5), comprenant une plate-forme de base (7) et un groupe structurel récepteur (6) susceptible d'être monté comme un ensemble sur la plate-forme de base (7) et destiné à la réception du compteur électrique (4, 5), dans lequel le groupe structurel récepteur (6) comprend la totalité des éléments nécessaires pour l'accouplement électrique et mécanique du compteur électrique (4, 5) et est réalisé pour l'accouplement du compteur électrique (4, 5) par translation du compteur électrique (4, 5) parallèlement à la plate-forme de base (7) de telle façon que des pièces de contact (8) qui dépassent postérieurement du compteur électrique (4, 5) viennent en contact électrique avec des éléments de raccordement prévus à l'intérieur du groupe structurel récepteur, et que des éléments en crochet (9) prévus du côté postérieur engagent par l'arrière des parties du boîtier du groupe structurel récepteur (6),
dans lequel, en vue de former un siège pour le groupe structurel récepteur (6) ou plusieurs sièges destinés respectivement à un tel groupe structurel récepteur (6), il est prévu une traversée respective dans la plate-forme de base (7) ou bien la plate-forme de base (7) comprend au moins une partie (13) susceptible d'être rompue au niveau d'emplacements affaiblis (14) en vue de former un tel siège pour le groupe structurel récepteur (6), le groupe structurel récepteur (6) est susceptible d'être enfiché de manière à s'enclencher sur la plate-forme de base (7, 7a), et s'engage dans le siège avec des prolongements (20) du groupe structurel récepteur (6) dans des renfoncements de bordure (21) de la plate-forme de base (7) ou avec plusieurs paires d'ergots d'enclenchement en saillie (10a, 10a') dans des évidements (19) d'un rabat de la plate-forme de base (7a), et des lignes de raccordement (11, 12) guidées le long du groupe structurel récepteur (6) sont posées derrière la plate-forme de base.

2. Système selon la revendication 1,
**caractérisé en ce que** le groupe structurel récepteur (6, 6a) est susceptible d'être monté sur la plate-forme de base depuis le côté postérieur et/ou depuis le côté antérieur de la plate-forme de base (7, 7a).

3. Système selon l'une des revendications 1 ou 2,
**caractérisé en ce que** le groupe structurel récepteur (6) est préfabriqué avec des lignes (11, 12) qui mènent dans des chambres de raccordement (2, 3).

4. Système selon l'une des revendications 1 à 3,
**caractérisé en ce qu'**il est prévu des moyens (16, 17) pour bloquer le groupe structurel récepteur (6) dans sa position de montage sur la plate-forme de base (7).

5. Système selon la revendication 4,
**caractérisé en ce que** le blocage est formé par une partie du compteur électrique (4).

6. Système selon la revendication 5,
**caractérisé en ce qu'**un élément formant le blocage comprend des moyens (18) pour le démontage du groupe structurel récepteur.

7. Système selon l'une des revendications 1 à 6,
**caractérisé en ce qu'**un élément (10) formant une liaison à enclenchement comprend des moyens (18) pour libérer la liaison à enclenchement.

8. Système selon la revendication 6 ou 7,
**caractérisé en ce que** l'élément (10) est bloqué par le compteur électrique (4).

9. Système selon l'une des revendications 1 à 7,
**caractérisé en ce que** le groupe structurel récepteur est préfabriqué avec des lignes de raccordement au moins partiellement rigides, préformées en correspondance de la géométrie de raccordement.

10. Système selon la revendication 9,
**caractérisé en ce que** les lignes rigides du groupe structurel récepteur préfabriqué sont reliées à une barrette à borne, en particulier une borne de ramification de ligne principale.

11. Système selon la revendication 10,
**caractérisé en ce que** la barrette à borne est susceptible d'être accouplée à la plate-forme de base et/ou à un rail profilé en chapeau dans une chambre de raccordement.

12. Système selon l'une des revendications 9 à 11,
**caractérisé en ce que** les lignes de raccordement rigides forment une pièce de contact de la barrette à borne, susceptible d'être reliée à une autre ligne de raccordement.

13. Système selon l'une des revendications 1 à 12,
**caractérisé en ce que** le groupe structurel récepteur (6) est préfabriqué avec des lignes (11, 12) qui s'éloignent du groupe structurel aussi bien vers le haut que vers le bas.

14. Système selon l'une des revendications 9 à 12,
**caractérisé en ce que** les lignes de raccordement rigides viennent directement en contact avec une tige de contact du compteur électrique.

15. Système selon l'une des revendications 1 à 14,
**caractérisé en ce qu'**une ligne neutre est passée sans interruption à travers le groupe structurel récepteur et établit un contact à l'intérieur du groupe structurel, le cas échéant au moyen d'un contact à couteau.

16. Système selon la revendication 15,
**caractérisé en ce que** la ligne neutre est au moins partiellement rigide, et vient en contact directement avec une pièce de contact du compteur électrique, le cas échéant sans intermédiaire et le cas échéant avec effet élastique.
